# EUROPEAN PATENT SPECIFICATION

(11) **EP 2 146 379 B1**
(45) Date of publication and mention of the grant of the patent: **28.01.2015**
(21) Application number: 09165080.4
(22) Date of filing: 09.07.2009
(51) Int. Cl.: H01L 29/786

(54) **Transistor comprising ZnO based channel layer**
Transistor mit ZnO-basierter Kanalschicht
Transistor comprenant une couche de canal à base de ZnO

(30) Priority: 14.07.2008 KR 20080068344; 17.04.2009 KR 20090033846
(43) Date of publication of application: 20.01.2010
(73) Proprietor: Samsung Electronics Co., Ltd., Suwon-si, Gyeonggi-do, 443-742 (KR)
(72) Inventor: Kim, Sun-il, Yongin-si Gyeonggi-do (KR); Kim, Sang-wook, Yongin-si Gyeonggi-do (KR); Park, Jae-chul, Yongin-si Gyeonggi-do (KR); Kim, Chang-jung, Yongin-si Gyeonggi-do (KR); Song, I-hun, Yongin-si Gyeonggi-do (KR)
(74) Representative: Greene, Simon Kenneth

(56) References cited:
- EP-A- 2 061 086
- WO-A-2005/074038
- US-A1- 2007 063 211

## Description

### BACKGROUND OF THE INVENTION

One or more embodiments of the present invention relates to a semiconductor device, and more particularly, to a channel layer and a transistor including the same.

Transistors are commonly used as switching devices or driving devices in electronic devices. In particular, a thin film transistor (TFT) can be formed on a glass substrate or a plastic substrate. As a result, TFTs are often used in flat panel display apparatuses such as liquid crystal display apparatuses and organic light emitting display apparatuses.

In order to improve the operational characteristics of a transistor, attempts have been made to utilize an oxide semiconductor layer as a channel layer of the transistor. This conventional method is mainly employed for manufacturing TFTs for flat panel display apparatuses. However, the threshold voltage is difficult to control in a transistor having an oxide semiconductor layer as the channel layer (e.g., a conventional oxide transistor).

A conventional oxide transistor uses an n-type oxide layer as the channel layer. To obtain a high ON/OFF current ratio and a small subthreshold slope (SS), the n-type oxide layer needs to have a high carrier concentration and a high crystallinity. In order to control the threshold voltage, if the carrier concentration of the n-type oxide layer is reduced, mobility is reduced. Thus, the ON/OFF current ratio is reduced and the SS is increased, thereby degrading the operational characteristics of the transistor. In addition, if the carrier concentration of the n-type oxide layer is increased, the threshold voltage is so reduced to the negative (-) side that enhancement mode transistors cannot be manufactured.

WO2005/074038 describes a transistor with an oxide channel. A thin boundary layer adjacent to the gate insulator is used to control the threshold voltage.

EP 2061086 was published on 20 May 2009, after the priority date in this case. It describes an oxide FET which in embodiments has a multiple layer channel. A lower carrier concentration layer is provided away from the gate insulator.

### SUMMARY OF THE INVENTION

In an aspect of the invention there is provided a transistor according to claim 1.

Additional aspects and/or advantages will be set forth in part in the description which follows and, in part, will be apparent from the description, or may be learned by practice of the invention.

One of the lower layer and the upper layer, which is closer to the gate, may determine mobility of the transistor.

One of the lower layer and the upper layer, which is farther from the gate, may have a thickness of about 10 to 2000 Å .

The thickness of one of the lower layer and the upper layer, which is farther from the gate, may be the same as or greater than the thickness of the other layer.

One of the lower layer and the upper layer, which is closer to the gate, is selected from the group consisting of an indium zinc oxide (IZO), an indium tin oxide (ITO).

The thickness of one of the lower layer and the upper layer, which is farther from the gate, may be the same as or greater than the thickness of the other layer.

The transistor may be a TFT having a top gate or bottom gate structure.

### BRIEF DESCRIPTION OF THE DRAWINGS

These and/or other aspects and advantages will become apparent and more readily appreciated from the following description of the embodiments, taken in conjunction with the accompanying drawings of which:
FIG. 1 is a cross-sectional view of a transistor according to an example embodiment of the present invention;
FIG. 2 is a cross-sectional view of a transistor according to another example embodiment of the present invention;
FIG. 3 is a graph illustrating gate voltage V_{g}-drain current I_{d} characteristics of transistors according to an example embodiment and comparative embodiments;
FIG. 4 is a linear scale graph of FIG. 3;
FIG. 5 is a graph illustrating gate voltage V_{g}-drain current I_{d} characteristics of transistors according to example embodiments of the present invention with respect to the thickness of an indium zinc oxide (IZO) layer of the transistors;
FIG. 6 is a graph illustrating a threshold voltage (V) and mobility (cm²/V·s) of transistors according to example embodiments of the present invention with respect of the thickness of an IZO layer of the transistors;
FIG. 7 is a graph illustrating gate voltage V_{g}-drain current I_{d} characteristics of transistors according to an example embodiment and comparative embodiments;
FIG. 8 is a graph illustrating gate voltage V_{g}-drain current l_{d} characteristics of transistors according to example embodiments of the present invention with respect to the thickness of an ITO layer of the transistors;
FIG. 9 is a graph illustrating a threshold voltage (V) and mobility (cm²/V·s) of transistors according to example embodiments of the present invention with respect of the thickness of an ITO layer of the transistors;
FIGS. 10A to 10D are cross-sectional views of a method of manufacturing a transistor according to an example embodiment of the present invention; and
FIGS. 11A to 11D are cross-sectional views of a method of manufacturing a transistor according to another example embodiment of the present invention.

### DETAILED DESCRIPTION

Various example embodiments will now be described more fully with reference to the accompanying drawings in which some example embodiments are shown.

Detailed illustrative example embodiments are disclosed herein. However, specific structural and functional details disclosed herein are merely representative for purposes of describing example embodiments. This invention may, however, may be embodied in many alternate forms and should not be construed as limited to only the example embodiments set forth herein.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or," includes any and all combinations of one or more of the associated listed items.

It will be understood that when an element or layer is referred to as being "formed on," another element or layer, it can be directly or indirectly formed on the other element or layer. That is, for example, intervening elements or layers may be present. In contrast, when an element or layer is referred to as being "directly formed on," to another element, there are no intervening elements or layers present. Other words used to describe the relationship between elements or layers should be interpreted in a like fashion (e.g., "between," versus "directly between," "adjacent," versus "directly adjacent," etc.).

The terminology used herein is for the purpose of describing particular embodiments only and is not intended to be limiting of example embodiments. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

In the drawings, the thicknesses of layers and regions are exaggerated for clarity. Like reference numerals in the drawings denote like elements.

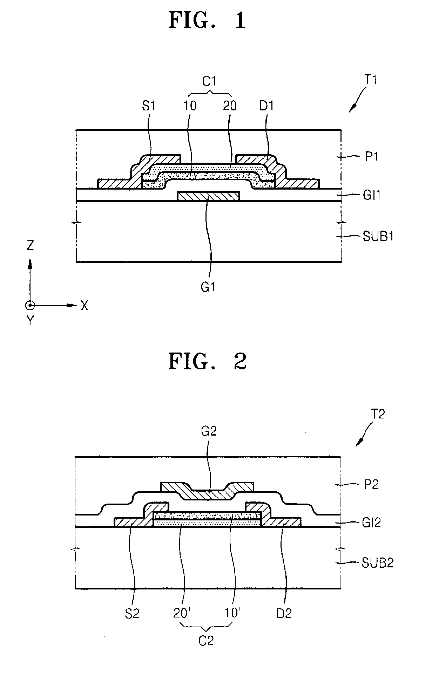

FIG. 1 is a cross-sectional view of a transistor T1 according to an example embodiment of the present invention. The transistor T1 may be a thin film transistor (TFT) which has a bottom gate structure, wherein a gate G1 is formed below a channel layer C1.

Referring to FIG. 1, the gate G1 is formed on a substrate SUB1. The substrate SUB1 may be a silicon substrate, a glass substrate, or a plastic substrate. The substrate SUB1 may or may not be transparent. A gate insulating layer Gl1 may be formed on the substrate SUB1 so as to cover the gate G1. The gate insulating layer Gl1 may be a silicon oxide layer, a silicon nitride layer, or another suitable material layer. The channel layer C1 may be formed on the gate insulating layer Gl1 above the gate G1. The channel layer C1 may have a width in an X axis direction that is greater than that of the gate G1 in the X axis direction. The channel layer C1 has a multi-layered structure including at least two oxide layers having different mobility and/or carrier density. For example, the channel layer C1 has a double-layered structure including a first oxide layer (first layer) 10 and a second oxide layer (second layer) 20 formed on the first layer 10. The first layer 10 is disposed relatively closer to the gate G1 compared to the second layer 20. In this regard, the mobility of the first layer 10 is greater than that of the second layer 20. The carrier density of the first layer 10 may be greater than that of the second layer 20. Mobility and carrier density of a material will be described in more detail. Mobility and carrier density of a material are independent variables. However, carrier density is generally in proportion to mobility in an oxide. That is, an oxide with high carrier density may have high mobility. However, an oxide with high carrier density may have low mobility in some cases. Meanwhile, as carrier density and/or mobility of an oxide layer used as a channel layer increase, mobility of a transistor including the oxide layer increases. However, a transistor including an oxide layer having low mobility, as a channel layer, may have high mobility when the carrier density of the oxide layer is high. Carrier density and/or mobility of a channel material influences not only mobility but also threshold voltage of a transistor. For example, the threshold voltage of a transistor may move to the positive (+) side as the carrier density of the channel material decreases. If the channel layer C1 is fabricated by stacking the first and second layers 10 and 20 having different carrier densities and/or mobilities according to exemplary embodiments, mobility and threshold voltage of transistors including the channel layer C1 may be easily controlled. This will be described in more detail.

The first layer 10 may be disposed relatively closer to the gate G1 compared to the second layer 20, and may increase the mobility of the transistor T1. That is, the transistor T1 including the channel layer C1 formed of the first layer 10 and the second layer 20 may have a higher mobility compared to a transistor including a channel layer formed only of a material of the second layer 20. Since the first layer 10 may have higher carrier density and/or mobility than the second layer 20, the mobility of the transistor T1 may increase. Even though the first layer 10 has lower mobility, the mobility of the transistor T1 may increase due to the first layer 10 if the first layer 10 has high carrier density. Meanwhile, the threshold voltage of the transistor T1 may be controlled by the second layer 20 rather than by the first layer 10 if the thickness of the first layer 10 is thin. For example, the threshold voltage of the transistor T1 may be controlled according to materials, compositions and carrier concentration of the second layer 20, if the first layer 10 is sufficiently thin. Since the second layer 20 may have lower carrier density and/or mobility than the first layer 10, the threshold voltage of the transistor T1 including the channel layer C1 formed of the first layer 10 and the second layer 20 may move to the positive (+) side compared to that of a transistor including a channel layer formed only of a material of the first layer 10. Thus, the transistor T1 may be an enhancement mode transistor having a high mobility and a positive (+) threshold voltage. However, if the first layer 10 becomes thick (more than a predetermined or given critical thickness), the influence of the first layer 10 on the threshold voltage of the transistor T1 may increase. In this case, the threshold voltage of the transistor T1 may be influenced by both of the first layer 10 and the second layer 20. As the influence of the first layer 10 increases, the threshold voltage of the transistor T1 may move the negative (-) side. If the first layer 10 is too thick, the threshold voltage of the transistor T1 may be controlled by the first layer 10 rather than the second layer 20.

For example, the first layer 10 is a layer at least one of an indium zinc oxide (IZO), an indium tin oxide (ITO). The second layer 20 is formed of a gallium indium zinc oxide (GIZO) layer. The second layer 20 may be doped with Group IV elements such as Sn or another suitable element instead of Group III elements. The thickness of the first layer 10 is 3 to 5 nm (30 to about 50 Å). If the first layer 10 is too thin, the effect of the first layer 10 on increasing the mobility of the transistor T1 may be reduced. On the other hand, if the first layer 10 is too thick, the effect of the second layer 20 on increasing the threshold voltage of the transistor T1 may be reduced since a channel is not easily formed in the second layer 20. That is, as the thickness of the first layer 10 increases, the threshold voltage of the transistor T1 may be influenced by both of the first and second layers 10 and 20. If the first layer 10 is too thick, the threshold voltage of the transistor T1 may be determined not by the second layer 20 but by the first layer 10. Thus, the threshold voltage of the transistor T1 may be easily controlled for its purposes. If the threshold voltage of the transistor T1 needs to be moved to the positive (+) side, the thickness of the first layer 10 may be reduced so that the effect of the second layer 20 on increasing the threshold voltage may be increased. On the other hand, if the threshold voltage of the transistor T1 needs to be moved to the negative (-) side, the first layer 10 may have a sufficient thickness so that the threshold voltage of the transistor T1 may be reduced by the first layer 10. The thickness of the first layer 10 may be about 3 to 5 nm (30 to about 50 Å) so that the threshold voltage of the transistor T1 may be increased by the second layer 20. However, the thickness of the first layer 10, suitable to obtain the effect of the second layer 20 on increasing the threshold voltage, may vary according to materials of the first and second layers 10 and 20. In addition, the thickness may vary according to the size and type of the transistor. Meanwhile, the thickness of the second layer 20 may be about 1 to 200 nm (10 to about 2000 A), which may be equal to or greater than that of the first layer 10.

A source electrode S1 and a drain electrode D1 may be formed on the gate insulating layer G11 so as to respectively contact opposing sides of the channel layer C1. Each of the source electrode S1 and the drain electrode D1 may be a single metal layer or a multiple metal layer. The source electrode S1 and the drain electrode D1 may be formed of the same metal used to form the gate G1. Alternatively, the source electrode S1 and the drain electrode D1 may be formed of a different material from that used to form the gate G1. A passivation layer P1 may be formed on the gate insulating layer GI1 so as to cover the channel layer C1, the source electrode S1, and the drain electrode D1. The passivation layer P1 may be a silicon oxide layer or a silicon nitride layer. Meanwhile, the gate G1 may have a thickness of about 50 to about 300 nm. The gate insulating layer GI1 may have a thickness of about 50 to about 300 nm. The source electrode S1 may have a thickness of about 10 to about 200 nm. The drain electrode D1 may have a thickness of about 10 to about 200 nm.

FIG. 2 is a cross-sectional view of a transistor T2 according to another example embodiment of the present invention. The transistor T2 may be a TFT which has a top gate structure, wherein a gate G2 is formed above a channel layer C2.

Referring to FIG. 2, the channel layer C2 is formed on a substrate SUB2. The channel layer C2 may have a structure in which the channel layer C1 of FIG. 1 is turned over. That is, the channel layer C2 of FIG. 2 may have a structure in which a second layer 20' corresponding to the second layer 20 of FIG. 1 and a first layer 10' corresponding to the first layer 10 of FIG. 1 are sequentially formed on the substrate SUB2. A source electrode S2 and a drain electrode D2 may be formed on the substrate SUB2 so as to respectively contact opposing sides of the channel layer C2. A gate insulating layer GI2 may be formed on the substrate SUB2 so as to cover the channel layer C2, the source electrode S2, and the drain electrode D2. A gate G2 may be formed on the gate insulating layer GI2. The gate G2 may be formed above the channel layer C2. Accordingly, the first layer 10' is disposed closer to the gate G2 compared to the second layer 20'. A passivation layer P2 may be formed on the gate insulating layer GI2 so as to cover the gate G2.

The materials for forming the substrate SUB2, the first layer 10', the second layer 20', the source electrode S2, the drain electrode D2, the gate insulating layer GI2, the gate G2, and the passivation layer P2 of FIG. 2 may be respectively the same as those of the substrate SUB1, the first layer 10, the second layer 20, the source electrode S1, the drain electrode D1, the gate insulating layer GI1, the gate G1, and the passivation layer P1 of FIG. 1. Similarly, the thicknesses of the various elements of FIG. 2 may be the same as those of FIG. 1. In addition, functions of the first layer 10' and the second layer 20' of FIG. 2 may be the same as those of the first layer 10 and the second layer 20 of FIG. 1.

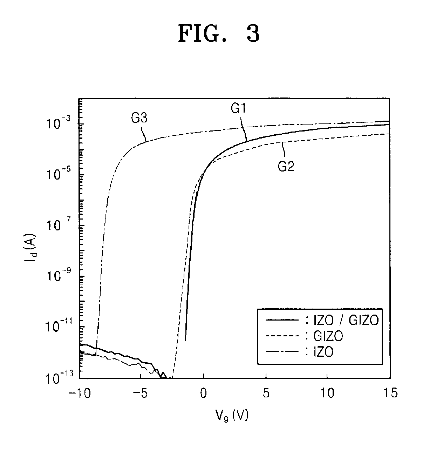

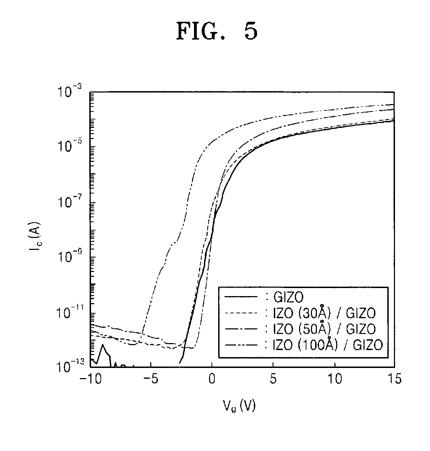

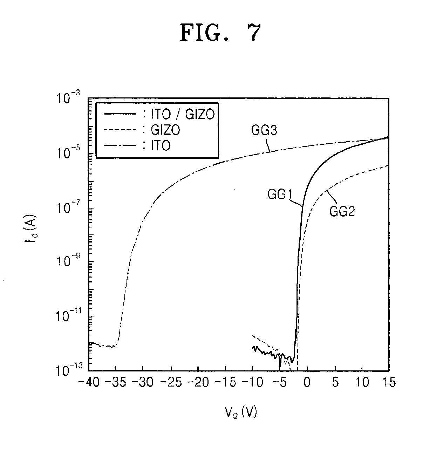

FIG. 3 is a graph illustrating gate voltage V_{g}-drain current I_{d} characteristics of transistors according to a first example embodiment, a first comparative embodiment and a second comparative embodiment. A first graph G1 of FIG. 3 illustrates gate voltage V_{g}-drain current I_{d} characteristics of a transistor according to the first example embodiment (hereinafter, a first transistor), for example, a transistor having the structure of FIG. 1, wherein the first layer 10 is an IZO layer and the second layer 20 is a GIZO layer. In this regard, the IZO layer may have a thickness of about 5nm (50 Å), and the GIZO layer may have a thickness of about 60 nm (600 Å). A second graph G2 of FIG. 3 illustrates gate voltage V_{g}-drain current I_{d} characteristics of a transistor according to the first comparative embodiment, wherein the channel layer is a GIZO single layer having a thickness of about 600 Å. A third graph G3 of FIG. 3 illustrates gate voltage V_{g}-drain current I_{d} characteristics of a transistor according to the second comparative embodiment, wherein the channel layer is an IZO single layer having a thickness of about 500 Å. Meanwhile, the drain voltage may be 1 V in FIG. 3, and the same drain voltage may be used in order to obtain graphs of FIGS. 5 and 7.

Upon comparing the first and second graphs G1 and G2 of FIG. 3, the ON current of the first graph G1 is about 10⁻³ A, which is about three times greater than the ON current (about 3×10⁻⁴ A) of the second graph G2. Mobility of the first transistor is about three times greater than that of the transistor according to the first comparative embodiment. The mobility and a subthreshold slope (SS) of the transistors are shown in Table 1 below.

**Table 1**

| Channel layer | Mobility (cm²/V·s). | Subthreshold slope (V/dec) |
|---|---|---|
| IZO/GIZO double layer (example embodiment) | 52 | 0.19 |
| GIZO single layer (comparative embodiment) | 19 | 0.19 |

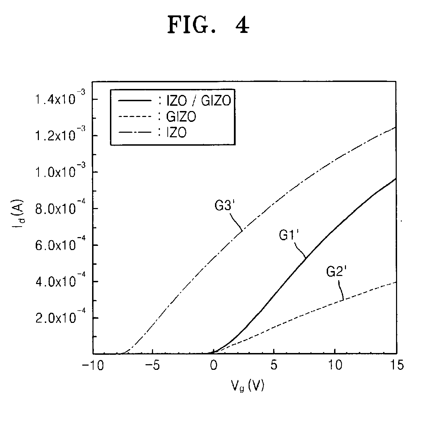

FIG. 4 is a linear scale graph of the first to third graphs G1 to G3 of FIG. 3. The first to third graphs G1' to G3' of FIG. 4 respectively correspond to the first to third graphs G1 to G3 of FIG. 3. A gate voltage at a point where a tangent line of each of the first to third graphs G1' to G3' meets the X-axis is a threshold voltage of the transistors.

Referring to FIG. 4, the threshold voltage of the transistor of the first graph G1' is about 0.31 V, and the threshold voltage of the transistor of the second graph G2' is about -0.60 V. That is, the threshold voltage of the first transistor shown in the first graph G1' is similar to that of the transistor according to the first comparative embodiment shown in the second graph G2'. Meanwhile, the transistor of the third graph G3', i.e., the transistor including the IZO single layer as the channel layer according to the second comparative embodiment, has a low threshold voltage of about -8 V. As a result, the transistor according to the second comparative embodiment is not an enhancement mode transistor but a depletion mode transistor.. As described above, while the first transistor has a threshold voltage which is similar to that of the transistor according to the first comparative embodiment and has a positive (+) value, the transistor according to the second comparative embodiment has a relatively low threshold voltage which has a negative (-) value. Since the first transistor includes the IZO/GIZO channel layer, the transistor according to the first comparative embodiment includes the GIZO channel layer, and the transistor according to the second comparative embodiment includes the IZO channel layer, the threshold voltage of the first transistor is determined not by the IZO layer but by the GIZO layer.

That is, if the GIZO single layer is used as the channel layer as in the first comparative embodiment, the transistor may not have high mobility. If the IZO single layer is used as the channel layer as in the second comparative embodiment, the threshold voltage is so low that it is difficult to manufacture the enhancement mode transistor. However, according to an example embodiment, an enhancement mode transistor having high mobility may be manufactured. In this regard, the IZO layer of the channel layer (IZO/GIZO) of the first transistor according to an example embodiment has a thin thickness of about 5 nm (50 Å). If the threshold voltage needs to be reduced, the thickness of the IZO layer of the channel layer (IZO/GIZO) is increased to increase the effect of the IZO layer on the threshold voltage.

FIG. 5 is a graph illustrating gate voltage V_{g}-drain current I_{d} characteristics of transistors according to example embodiments of the present invention, which include an IZO layer as the first layer 10 and a GIZO layer as a the second layer 20, with respect to the thickness of an IZO layer of the transistors. The solid line in FIG. 5 indicates the characteristics of the transistor using the GIZO single layer without the IZO layer as the channel layer.

Referring to FIG. 5, the gate voltage V_{g}-drain current I_{d} characteristics of the transistor having a thin IZO layer having a thickness of about 3nm (30 Å) are similar to those of the transistor having the GIZO single layer. If the thickness of the IZO layer is about 50 Å, the threshold voltage of the transistor is similar to that of a transistor including a GIZO single layer as the channel layer, but the ON current is significantly increased. The increase in the ON current indicates the increase in the mobility of the transistor. In addition, if the thickness of the IZO layer is about 10nm (100 Å), the graph moves to the negative (-) side. Here, the mobility of the transistor is farther increased in comparison to that of the transistor including the IZO layer having a thickness of 5nm (50 Å). The gate voltage V_{g}-drain current I_{d} characteristics of the transistor including a too thin IZO layer are similar to those of the transistor including the GIZO single layer as the channel layer. The gate voltage V_{g}-drain current I_{d} characteristics of the transistor including a too thick IZO layer are similar to those of the transistor according to the second comparative embodiment, i.e., the transistor including the IZO single layer as the channel layer. The thickness of the IZO layer may be controlled for its purposes.

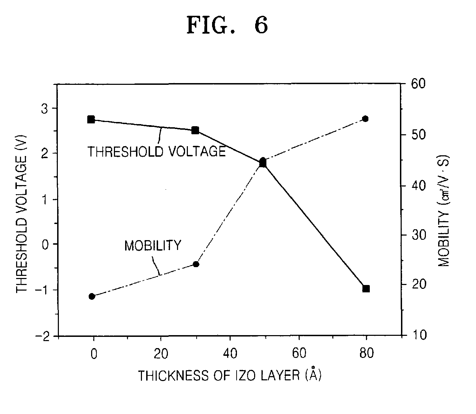

FIG. 6 is a graph illustrating a threshold voltage and mobility of transistors according to example embodiments of the present invention with respect of the thickness of an IZO layer of the transistors.

Referring to FIG. 6, as the thickness of the IZO layer increases, the mobility increases and the threshold voltage decreases. In particular, when the thickness of the IZO layer is about 3 to 5 nm (30 to 50 Å), a variation in mobility is maximized. As the thickness of the IZO layer increases, a variation in threshold voltage increases.

FIG. 7 is a graph illustrating gate voltage V_{g}-drain current I_{d} characteristics of transistors according to a second example embodiment, a third comparative embodiment, and a fourth comparative embodiment. A first graph GG1 of FIG. 7 illustrates gate voltage V_{g}-drain current I_{d} characteristics of a transistor according to the second example embodiment (hereinafter, a second transistor), for example, a transistor having the structure of FIG. 1, wherein the first layer 10 is an ITO layer and the second layer 20 is a GIZO layer. In this regard, the ITO layer may have a thickness of about 5nm (50 Å). The GIZO layer may have a thickness of about 60nm (600 Å). The second graph GG2 of FIG. 7 illustrates gate voltage V_{g}-drain current I_{d} characteristics of a transistor according to the third comparative embodiment, wherein the channel layer is a GIZO single layer having a thickness of about 60nm (600 Å). A third graph of GG3 of FIG. 7 illustrates gate voltage V_{g}-drain current I_{d} characteristics of a transistor according to the fourth comparative embodiment, wherein the channel layer is an ITO single layer having a thickness of about 5nm (50Å). The transistor according to the third comparative embodiment has a structure similar to that of the transistor according to the first comparative embodiment described with reference to FIG. 3. However, conditions for forming the two transistors are slightly different.

Upon comparing the first and second graphs GG1 and GG2 of FIG. 7, the ON current of the first graph GG1 is about 5×10⁻⁵ A, which is about ten times greater than the ON current (about 5×10⁻⁶ A) of the second graph GG2. Mobility of the second transistor shown in the first graph GG1 is about ten times greater than the transistor according to the third comparative embodiment shown in the second graph GG2. A tangent line of the first graph GG1 at a turn-on point is slightly greater than that of the second graph GG2. That is, the subthreshold slope (SS) of the second transistor is less than that of the transistor according to the third comparative embodiment. That is, the turn-on speed of the second transistor including the double layered channel layer is faster than that of the transistor including the single layered channel layer according to the third comparative embodiment. The mobility, the SS, and the threshold voltage of the transistors are shown in Table 2 below.

**Table 2**

| Channel layer | Mobility (cm²/V·s) | Subthreshold slope (SS) (V/dec) | Threshold voltage (V) |
|---|---|---|---|
| ITO/GIZO double layer (example embodiment) | 104 | 0.25 | 0.50 |
| GIZO single layer (comparative embodiment) | 13 | 0.35 | 0.75 |

When the single oxide layer is used as the channel layer as in a conventional transistor, the carrier concentration of the channel layer needs to be decreased in order to move the threshold voltage to the positive (+) side, thereby decreasing the mobility of the transistor. However, according to embodiments of the present invention, a transistor having a desired threshold voltage, excellent mobility and SS characteristics may be manufactured by using a double layered oxide layer as the channel layer.

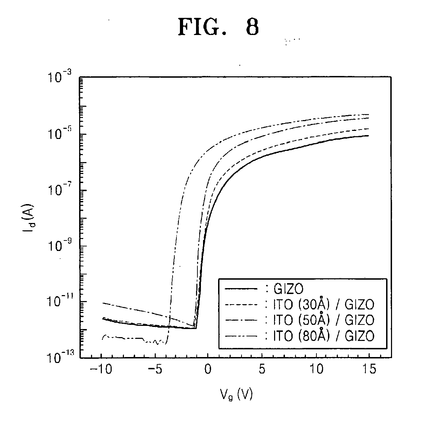

FIG. 8 is a graph illustrating gate voltage V_{g}-drain current I_{d} characteristics of transistors according to example embodiments of the present invention including an ITO layer and a GIZO layer, respectively as a first layer 10 and a second layer 20, with respect to the thickness of an ITO layer of the transistors. The solid line in FIG. 8. indicates the characteristics of the transistor using the GIZO single layer without the ITO layer as the channel layer.

The results of FIG. 8 is similar to those of FIG. 5. That is, the gate voltage V_{g}-drain current I_{d} characteristics of the transistor having a thin ITO layer having a thickness of about 3 nm (30 Å) are similar to those of the transistor having the GIZO single layer, but ON current is increased. The threshold voltage of the transistor having a ITO layer having a thickness of about 5nm (50 Å) is similar to that of the transistor having the GIZO single layer as the channel layer, but ON current is significantly increased. The increase in ON current indicates the increase in the mobilities of the transistor. In addition, if the thickness of the ITO layer is about 80 Å, the graph moves to the negative (-) side. In this regard, the mobility of the transistor somewhat increases compared with the transistor including the ITO layer having a thickness of 5 nm (50 Å).

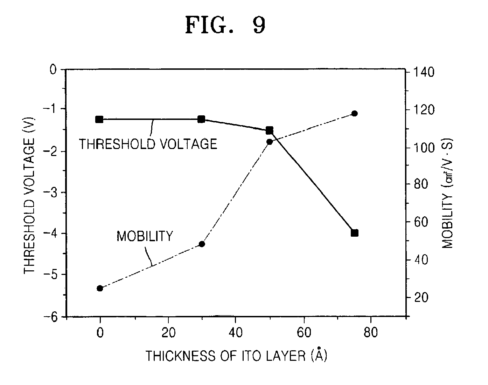

FIG. 9 is a graph illustrating a threshold voltage (V) and mobility (cm²/V·s) of transistors according to example embodiments of the present invention with respect of the thickness of an ITO layer of the transistors.

Referring to FIG. 9, as the thickness of the ITO layer increases, the mobility increases and the threshold voltage decreases. In particular, when the thickness of the ITO layer is about 3 to 5 nm (30 to 50 Å), a variation in mobility is maximized. As the thickness of the ITO layer increases to greater than 5 nm (50 A), a variation in threshold voltage increases.

Hereinafter, a method of manufacturing a transistor according to example embodiments of the present invention will be described.

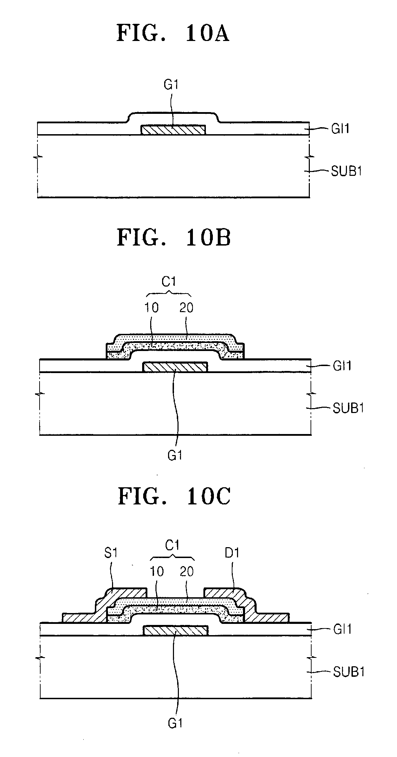

FIGS. 10A to 10D are cross-sectional views of a method of manufacturing a transistor according to an example embodiment. The transistor according to the example embodiment may be a TFT having a bottom gate structure. The transistor manufactured according to FIGS. 10A through 10D may correspond to the transistor of FIG. 1. Like reference numerals are used to indicate like elements.

Referring to FIG. 10A, a gate G1 may be formed on a substrate SUB1. A gate insulating layer Gl1 may be formed on the substrate SUB1 so as to cover the gate G1. The gate insulating layer Gl1 may be formed of a silicon oxide, a silicon nitride, or other suitable materials.

Referring to FIG. 10B, a channel layer C1 including a first layer 10 and a second layer 20, which are sequentially formed may be formed on the gate insulating layer Gl1. The channel layer C1 may be positioned above the gate G1. The first layer 10 and the second layer 20 may be deposited using a physical vapor deposition (PVD) method such as sputtering or evaporation, or may be patterned using the same mask layer.

Referring to FIG. 10C, a source electrode S1 and a drain electrode D1 may be formed on the gate insulating layer Gl1 so as to respectively contact the opposing ends of the channel layer C1 while leaving a portion of an upper surface of the channel layer C1 exposed. The source electrode S1 and the drain electrode D1 may each be formed as a single metal layer or a multiple metal layer.

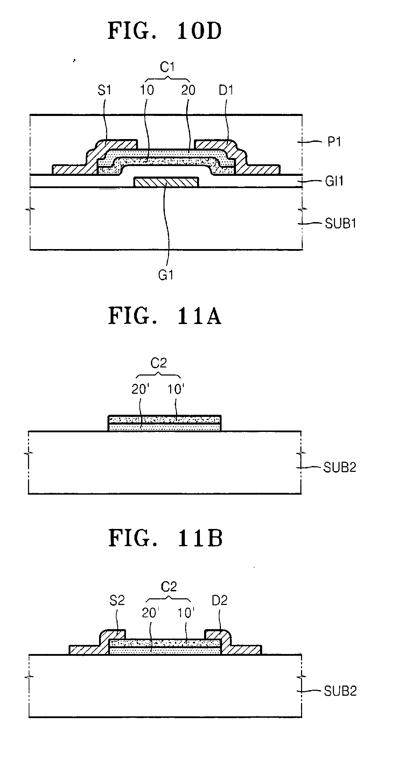

Referring to FIG. 10D, a passivation layer P1 may be formed on the substrate SUB1 so as to cover the exposed portion of the channel layer C1, the source electrode S1, and the drain electrode D1. The resulting structure may be annealed at a predetermined temperature to achieve a transistor according to example embodiments.

FIGS. 11A to 11D are cross-sectional views of a method of manufacturing a transistor according to another example embodiment. The transistor may be a TFT having a top gate structure. The transistor manufactured according to FIGS. 11A through 11D may correspond to the transistor of FIG. 2. Like reference numerals are used to indicate like elements.

Referring to FIG. 11A, a channel layer C2 may be formed on a substrate SUB2. The channel layer C2 may have a double layered structure including a second layer 20' and a first layer 10', which are sequentially formed on the substrate SUB2. The method of forming the first layer 10' and the second layer 20' may be similar to the method of forming the first layer 10 and the second layer 20 of FIG. 10B.

Referring to FIG. 11B, a source electrode S2 and a drain electrode D2 may be formed on the substrate SUB2 so as to respectively contact the opposing ends of the channel layer C2.

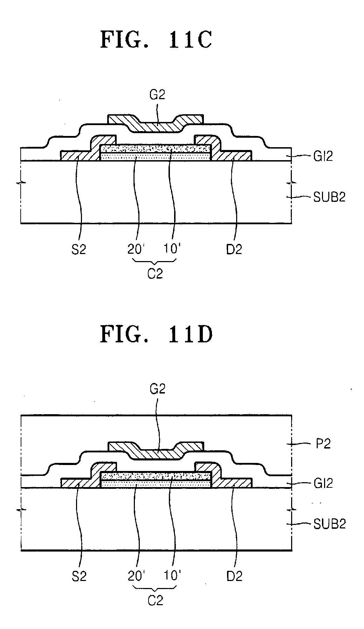

Referring to FIG. 11C, a gate insulating layer Gl2 may be formed on the substrate SUB1 so as to cover the exposed portion of the channel layer C2, the source electrode S2, and the drain electrode D2. A gate G2 may be formed on the gate insulating layer Gl2. The gate G2 may be positioned above the channel layer C2. The gate G2 may be formed of the same metal used to form the source electrode S2 and drain electrode D2. Alternatively, the gate G2 may be formed of a different material from that used to form the source electrode S2 and drain electrode D2.

Referring to FIG. 11D, a passivation layer P2 may be formed on the gate insulating layer Gl2 so as to cover the gate G2. The passivation layer P2 may be formed of a silicon oxide layer or a silicon nitride layer. The resulting structure may be annealed at a predetermined temperature to achieve a transistor according to example embodiments.

While example embodiments have been shown and described with reference to the accompanying drawings, the scope of the present application should not be construed as being limited to example embodiments. For instance, one of ordinary skill in the art would understand that the teachings herein may be applied to other transistors besides TFTs. Also, the constituent elements and structures of the transistors of FIGS. 1 and 2 may be modified in various forms. The transistors according to example embodiments may not be an enhancement mode transistors but depletion mode transistors. The transistors may be used not only for liquid crystal display (LCD) apparatuses and organic light-emitting display apparatuses but also for memory devices and logic devices. Therefore, the scope of the present application should not be interpreted as being unduly limited to the literal text of the detailed description.

While aspects of the present invention have been particularly shown and described with reference to differing embodiments thereof, it should be understood that these exemplary embodiments should be considered in a descriptive sense only and not for purposes of limitation. Descriptions of features or aspects within each embodiment should typically be considered as available for other similar features or aspects in the remaining embodiments.

While example embodiments have been disclosed herein, it should be understood that other variations may be possible. Such variations are not to be regarded as a departure from the scope of example embodiments of the present application, and all such modifications as would be obvious to one of ordinary skill in the art are intended to be included within the scope of the following claims.

## Claims

1. A thin film transistor (TFT) comprising:
a channel layer (C1,C2) comprising a lower layer (10,20') and an upper layer (20,10') which have different mobilites and/or different carrier densities and formed of different oxide materials;
a source (S1,S2) and a drain (D1,D2) which respectively contact the opposing ends of the channel layer;
a gate (G1,G2) for applying an electric field to the channel layer; and
a passivation layer (P1 ,P2);
wherein the one of the lower layer and the upper layer which is closer to the gate (10,10') has a thickness of 3 to 5 nm;
wherein the one of the lower layer and the upper layer (10,10'), which is closer to the gate, has higher mobility than the other layer (20,20'), which is farther from the gate;
wherein the one of the lower layer and the upper layer which is closer to the gate (10,10'), comprises at least one oxide selected from the group consisting of an indium zinc oxide (IZO), and an indium tin oxide (ITO); and
wherein the other one (20,20') of the lower layer and the upper layer, which is farther from the gate, is a gallium indium zinc oxide (GIZO); and
wherein a threshold voltage of the transistor is determined by the lower layer and the upper layer (10,10'20,20').

2. The transistor of any preceding claim, wherein the one (10,10'), of the lower layer and the upper layer, which is closer to the gate, determines mobility of the transistor.

3. The transistor of any preceding claim, being a thin film transistor (TFT) having a top gate structure

4. The transistor of any of claims 1 to 2 being a thin film transistor (TFT) having a bottom gate structure.

5. The transistor of any preceding claim, wherein the lower layer and the upper layer (10,10'20,20') have different carrier densities.

6. The transistor of claim 5, wherein the one of the lower layer and the upper layer which is closer to the gate (10,10'), has higher carrier density than the other layer which is farther from the gate (20,20').

## Patentansprüche

1. Dünnschichttransistor (TFT), umfassend:
eine Kanalschicht (C1, C2), mit einer unteren Schicht (10, 20') und einer oberen Schicht (20, 10'), die unterschiedliche Mobilitäten und/oder unterschiedliche Trägerdichten aufweisen und aus unterschiedlichen Oxidmaterialien gebildet sind;
eine Source (S1, S2) und eine Drain (D1, D2), die entsprechend die entgegengesetzten Enden der Kanalschicht berühren;
ein Gate (G1, G2) zum Anlegen eines elektrischen Felds an die Kanalschicht; und
eine Passivierungsschicht (P1, P2);
wobei die eine der unteren Schicht und der oberen Schicht, die sich näher an dem Gate (10, 10') befindet, eine Dicke von 3 bis 5 nm aufweist;
wobei die eine der unteren Schicht und der oberen Schicht (10, 10'), die sich näher an dem Gate befindet, eine höhere Mobilität aufweist als die andere Schicht (20, 20'), die weiter von dem Gate entfernt ist;
wobei die eine der unteren Schicht und der oberen Schicht, die sich näher an dem Gate (10, 10') befindet, mindestens ein Oxid umfasst, das aus der Gruppe ausgewählt ist, die aus einem Indiumzinkoxid (IZO) und einem Indiumzinnoxid (ITO) besteht; und
wobei die andere eine (20, 20') der unteren Schicht und der oberen Schicht, die weiter von dem Gate entfernt ist, ein Galliumindiumzinkoxid (GIZO) ist; und
wobei eine Schwellenspannung des Transistors bestimmt wird durch die untere Schicht und die obere Schicht (10, 10', 20, 20').

2. Transistor nach einem der vorstehenden Ansprüche, wobei die eine (10, 10') der unteren Schicht und der oberen Schicht, die sich näher an dem Gate befindet, die Mobilität des Transistors bestimmt.

3. Transistor nach einem der vorstehenden Ansprüche, bei dem es sich um einen Dünnschichttransistor (TFT) mit einer oberen Gate-Struktur handelt.

4. Transistor nach Anspruch 1 oder 2, bei dem es sich um einen Dünnschichttransistor (TFT) mit einer unteren Gate-Struktur handelt.

5. Transistor nach einem der vorstehenden Ansprüche, wobei die untere Schicht und die obere Schicht (10, 10', 20, 20') unterschiedliche Trägerdichten aufweisen.

6. Transistor nach Anspruch 5, wobei die eine der unteren Schicht und der oberen Schicht, die sich näher an dem Gate (10, 10') befindet, eine höhere Trägerdichte aufweist als die andere Schicht, die weiter von dem Gate (20, 20') entfernt ist.

## Revendications

1. Transistor à couches minces (TFT) comprenant :
une couche de canal (C1, C2) comprenant une couche inférieure (10, 20') et une couche supérieure (20, 10') qui ont différentes mobilités et/ou différentes densités de porteur de charge et sont formées de différents matériaux d'oxyde ;
une source (S1, S2) et un drain (D1, D2) qui sont en contact respectivement avec les extrémités opposées de la couche de canal ;
une grille (G1, G2) pour appliquer un champ électrique à la couche de canal ; et
une couche de passivation (P1, P2) ;
dans lequel la couche inférieure ou la couche supérieure qui est plus proche de la grille (10, 10') a une épaisseur de 3 à 5 nm ;
dans lequel la couche inférieure ou la couche supérieure (10, 10'), qui est plus proche de la grille, a une mobilité plus élevée que l'autre couche (20, 20'), qui est plus éloignée de la grille ;
dans lequel la couche inférieure ou la couche supérieure qui est plus proche de la grille (10, 10'), comprend au moins un oxyde choisi dans le groupe constitué d'un oxyde d'indium-zinc (IZO), et d'un oxyde d'indium-étain (ITO) ; et
dans lequel l'autre couche (20, 20'), parmi la couche inférieure et la couche supérieure, qui est plus éloignée de la grille, est un oxyde de gallium-indium-zinc (GIZO) ; et
dans lequel une tension de seuil du transistor est déterminée par la couche inférieure et la couche supérieure (10, 10', 20, 20').

2. Transistor selon l'une quelconque des revendications précédentes, dans lequel la couche (10, 10'), parmi la couche inférieure et la couche supérieure, qui est plus proche de la grille, détermine la mobilité du transistor.

3. Transistor selon l'une quelconque des revendications précédentes, qui est un transistor à couches minces (TFT) ayant une structure de grille supérieure

4. Transistor selon l'une quelconque des revendications 1 à 2 étant un transistor à couches minces (TFT) ayant une structure de grille inférieure.

5. Transistor selon l'une quelconque des revendications précédentes, dans lequel la couche inférieure et la couche supérieure (10, 10', 20, 20') ont des différentes densités de porteur de charge.

6. Transistor selon la revendication 5, dans lequel la couche inférieure ou la couche supérieure qui est plus proche de la grille (10, 10'), a une densité de porteur de charge plus élevée que l'autre couche qui est plus éloignée de la grille (20, 20').
